# EUROPEAN PATENT SPECIFICATION

(11) **EP 2 822 705 B1**
(45) Date of publication and mention of the grant of the patent: **07.09.2016**
(21) Application number: 13712890.6
(22) Date of filing: 06.03.2013
(51) Int. Cl.: B05D 7/00, B05D 1/00, H05K 3/28

(54) **COATED ELECTRICAL ASSEMBLY**
BESCHICHTETE ELEKTRISCHE BAUGRUPPE
ENSEMBLE ÉLECTRIQUE REVÊTU

(30) Priority: 06.03.2012 GB 201203927; 19.06.2012 US 201213527305; 14.09.2012 GB 201216467
(43) Date of publication of application: 14.01.2015
(73) Proprietor: Semblant Limited, London SW10 0XD (GB)
(72) Inventor: BROOKS, Andrew, Melbourn Cambridgeshire SG8 6UL (GB); VON WERNE, Timothy, London EC1M 4BU (GB)
(74) Representative: Milton, Christopher John
(86) International application number: PCT/GB2013/050550
(87) International publication number: WO 2013/132250

(56) References cited:
- WO-A1-2011/089009
- WO-A1-2011/104500
- US-A1- 2013 033 825
- FRANK FERDINANDI: "INTRODUCTION OF A NEW PCB SURFACE FINISH FOR THE ELECTRONICS INDUSTRY", SMTA INTERNATIONAL CONFERENCE PROCEEDINGS,, 10 April 2009 (2009-04-10), pages 1-6, XP007920180,

## Description

### Field of the Invention

The present invention relates to a coated electrical assembly and to methods of preparing a coated electrical assembly.

### Background to the Invention

Conformal coatings have been used for many years in the electronics industry to protect electrical assemblies from environmental exposure during operation. A conformal coating is a thin, flexible layer of protective lacquer that conforms to the contours of an electrical assembly, such as a printed circuit board, and its components.

There are 5 main classes of conformal coatings, according to the IPC definitions: AR (acrylic), ER (epoxy), SR (silicones), UR (urethanes) and XY (paraxylylene). Of these 5 types, paraxylylene (or parylene) is generally accepted to offer the best chemical, electrical and physical protection. However, the deposition process is time consuming and expensive, and the starting material is expensive.

Parylene is polymer with the following structure:

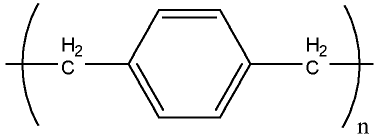

Parylene is deposited using a three stage vapour deposition process. A solid precursor is heated under vacuum and sublimes. It is important to appreciate that parylene, although sometimes erroneously called "paraxylene", is not in fact prepared from the compound paraxylene. In fact, the precursor is [2.2]paracyclophane:

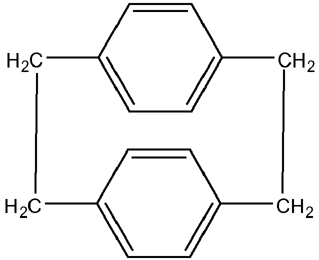

The chemical vapour is then passed through a high temperature furnace at around 680°C, so that the precursor splits into a reactive monomer. This reactive monomer then feeds into a deposition chamber and polymerizes on the surface of the substrate. Typical coating thicknesses for parylene are between 5 and 25 microns.

The parylene deposition technique described above is not ideal because of the high cost of the starting material, the high thermal energy consumption during monomer generation, the high vacuum requirements and the low growth rate.

WO 2011/089009 describes a method for the application of a conformal nanocoating by means of a low pressure plasma process.

There is therefore a need for conformal coatings that offer at least similar levels of chemical, electrical and physical protection as parylene, but that can be manufactured more easily and cheaply.

### Summary of the Invention

The present inventors have surprisingly found that plasma polymerization of relatively inexpensive precursor compounds and deposition of the resulting polymers results in a conformal coating with excellent properties. The present invention thus relates to an electrical assembly which has a conformal coating, wherein said conformal coating is obtainable by a method which comprises plasma polymerization of a compound of formula (I) as defined below and deposition of the resulting polymer and plasma polymerization of a fluorohydrocarbon and deposition of the resulting polymer. The invention also relates to a method for conformally coating an electrical assembly, which method comprises plasma polymerization of a compound of formula (I) as defined below and deposition of the resulting polymer and plasma polymerization of a fluorohydrocarbon and deposition of the resulting polymer.

The present invention thus relates to an electrical assembly which has a conformal coating, wherein said conformal coating is obtainable by a method which comprises:
(a) plasma polymerization of a compound of formula (I) and deposition of the resulting polymer onto at least one surface of the electrical assembly: 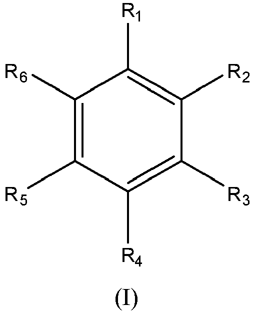 wherein:
   R₁ represents C₁-C₃ alkyl or C₂-C₃ alkenyl;
   R₂ represents hydrogen, C₁-C₃ alkyl or C₂-C₃ alkenyl;
   R₃ represents hydrogen, C₁-C₃ alkyl or C₂-C₃ alkenyl;
   R₄ represents hydrogen, C₁-C₃ alkyl or C₂-C₃ alkenyl;
   R₅ represents hydrogen, C₁-C₃ alkyl or C₂-C₃ alkenyl; and
   R₆ represents hydrogen, C₁-C₃ alkyl or C₂-C₃ alkenyl, and
(b) plasma polymerization of a fluorohydrocarbon and deposition of the resulting polymer onto the polymer formed in step (a).

The invention further relates to an electrical assembly which has a conformal coating, wherein said conformal coating is obtainable by a method which comprises:
(i) plasma polymerization of a fluorohydrocarbon and deposition of the resulting polymer onto at least one surface of the electrical assembly, and
(ii) plasma polymerization of a compound of formula (I) as defined above and deposition of the resulting polymer onto the polymer formed in step (i).

The invention also relates to a method for conformally coating an electrical assembly, which method comprises:
(a) plasma polymerization of a compound of formula (I) as defined above and deposition of the resulting polymer onto at least one surface of the electrical assembly, and
(b) plasma polymerization of a fluorohydrocarbon and deposition of the resulting polymer onto the polymer formed in step (a).

The invention further relates to a method for conformally coating an electrical assembly, which method comprises:
(i) plasma polymerization of a fluorohydrocarbon and deposition of the resulting polymer onto at least one surface of the electrical assembly, and
(ii) plasma polymerization of a compound of formula (I) as defined above and deposition of the resulting polymer onto the polymer formed in step (i).

The present inventors have surprisingly found that the coatings of the invention provide conformal coatings with excellent properties. In particular, it is finding of the invention that a multilayer coating comprising a layer of plasma polymerized fluorohydrocarbon and a layer of plasma polymerized compound of formula (I) provides a more effective conformal coating than would be expected for such a coating, based on the properties of single layer coatings of the polymers alone.

It is further finding of the invention been found that adding further layers of the plasma polymerized fluorohydrocarbon and/or the plasma polymerized compound of formula (I), such that the conformal coating comprises three or more layers, can provide further improvements in the properties of the conformal coating.

The improved performance of the conformal coating generally results in improved protection of the electrical assembly during operation.

A further advantage of the coatings of the invention is that the presence of two discrete polymer layers allows easy identification of the presence or absence of the coating on a given electrical assembly.

### Description of the Figures

Figure 1 shows an example of an electrical assembly of the invention which has a conformal coating.
Figures 2 to 5 shows cross sections through the conformal coating in Figure 1, and depict the structure of preferred coatings.
Figure 6 shows the Fourier transform infrared (FTIR) spectrum for a conventional parylene conformal coating.
Figure 7 shows the FTIR spectrum for a conformal coating prepared in Example 1, by plasma polymerization of 1,4-dimethylbenzene.
Figure 8 shows the FTIR spectrum for the multilayer conformal coatings prepared in Examples 2 to 4, which contain plasma polymerized 1,4-dimethylbenzene and plasma polymerized hexafluoropropylene.

### Detailed Description of the Invention

The conformal coating of the invention is obtainable by plasma polymerization of specific precursor compounds and deposition of the resulting polymers. The polymerization reactions occur *in situ.* Polymerization therefore typically occurs on the surface at which deposition occurs. Polymerization and deposition are thus typically simultaneous.

Plasma-polymerized polymers are a unique class of polymers which cannot be prepared by traditional polymerization methods. Plasma-polymerized polymers have a highly disordered structure and are generally highly crosslinked, contain random branching and retain some reactive sites. Plasma-polymerized polymers are thus chemically distinct from polymers prepared by traditional polymerization methods known to those skilled in the art. These chemical and physical distinctions are well known and are described, for example in Plasma Polymers Films, Hynek Biederman, Imperial College Press 2004*.*

Plasma polymerization is typically carried out in a reactor that generates a gas plasma which comprises ionized gaseous ions, electrons, atoms and/or neutral species. A reactor typically comprises a chamber, a vacuum system, and one or more energy sources, although any suitable type of reactor configured to generate a gas plasma may be used. The energy source may include any suitable device configured to convert one or more gases to a gas plasma. Preferably the energy source comprises a heater, radio frequency (RF) generator, and/or microwave generator.

Typically, the electrical assembly is placed in the chamber of a reactor and a vacuum system is used to pump the chamber down to pressures in the range of 10⁻³ to 10 mbar. One or more gases is typically then pumped into the chamber and an energy source generates a stable gas plasma. One or more precursor compounds is typically then be introduced, as gases and/or liquids, into the gas plasma in the chamber. When introduced into the gas plasma, the precursor compounds are typically ionized and/or decomposed to generate a range of active species in the plasma that polymerize to generate the polymer.

The exact nature and composition of the polymer deposited typically depends on one or more of the following conditions (i) the plasma gas selected; (ii) the particular precursor compound(s) used; (iii) the amount of precursor compound(s) (which may be determined by the combination of the pressure of precursor compound(s) and the flow rate); (iv) the ratio of precursor compound(s); (v) the sequence of precursor compound(s); (vi) the plasma pressure; (vii) the plasma drive frequency; (viii) the pulse width timing; (ix) the coating time; (x) the plasma power (including the peak and/or average plasma power); (xi) the chamber electrode arrangement; and/or (xii) the preparation of the incoming assembly.

Typically the plasma drive frequency is 1 kHz to 1 GHz. Typically the plasma power is 100 to 250 W, preferably 150 to 200 W, for example about 175 W. Typically the mass flow rate is 5 to 100 sccm, preferably 5 to 20 sccm, for example about 10 sccm. Typically the operating pressure is 10 to 100 mTorr, for example about 50 mTorr. Typically the coating time is 10 seconds to 20 minutes.

However, as a skilled person will appreciate, the preferred conditions will be dependent on the size and geometry of the plasma chamber. Thus, depending on the specific plasma chamber that is being used, it may be beneficial for the skilled person to modify the operating conditions.

It is preferable in the present invention to form the conformal coating by depositing a first polymer by plasma polymerization of a compound of formula (I), and then a second polymer by plasma polymerization of a fluorohydrocarbon. The resulting conformal coating will thus comprise two layers, which are preferably discrete. The first layer is in contact with surface of the electrical assembly and comprises the polymer formed by plasma polymerization of the compound of formula (I). The second layer is in contact with the first layer and comprises the polymer formed by plasma polymerization of the fluorohydrocarbon.

Alternatively, the conformal coating can be formed by depositing a first polymer by plasma polymerization of a fluorohydrocarbon, and then a second polymer by plasma polymerization of a compound of formula (I). The resulting conformal coating will thus comprise two layers, which are preferably discrete. The first layer is in contact with surface of the electrical assembly and comprises the polymer formed by plasma polymerization of the fluorohydrocarbon. The second layer is in contact with the first layer and comprises the polymer formed by plasma polymerization of the compound of formula (I).

The deposition process of the invention can be repeated as often as desired, to build up a conformal coating comprising multiple layers, which are preferably discrete. Where two or more layers comprising a polymer formed by plasma polymerization of a compound of formula (I) are present, each compound of formula (I) used may be the same or different, and are preferably the same. Where two or more layers comprising a polymer formed by plasma polymerization of a fluorohydrocarbon are present, each fluorohydrocarbon used may be the same or different, and are preferably the same.

It is generally preferred that the polymer which is deposited last, that is to say the polymer that forms the upper or environmentally exposed surface of the conformal coating, is obtainable by plasma polymerization of a fluorohydrocarbon. However, the polymer which is deposited last, that is to say the polymer that forms the upper or environmentally exposed surface of the conformal coating, can also be obtainable by plasma polymerization of a compound of formula (I).

A particularly preferred conformal coating of the present invention comprises four layers. This conformal coating is obtainable by (a) plasma polymerization of a first compound of formula (I) and deposition of the resulting polymer onto at least one surface of the electrical assembly, then (b) plasma polymerization of a first fluorohydrocarbon and deposition of the resulting polymer onto the polymer formed in step (a), then (c) plasma polymerization of a second compound of formula (I) and deposition of the resulting polymer onto the polymer formed in step (b), and then (d) plasma polymerization of a second fluorohydrocarbon and deposition of the resulting polymer onto the polymer formed in step (c). The compound of formula (I) and fluorohydrocarbon are preferably as defined below, and more preferably are 1,4-dimethylbenzene and hexafluoropropylene (C₃F₆).

A further particularly preferred conformal coating of the present invention comprises six layers. This conformal coating is obtainable by (a) plasma polymerization of a first compound of formula (I) and deposition of the resulting polymer onto at least one surface of the electrical assembly, then (b) plasma polymerization of a first fluorohydrocarbon and deposition of the resulting polymer onto the polymer formed in step (a), then (c) plasma polymerization of a second compound of formula (I) and deposition of the resulting polymer onto the polymer formed in step (b), then (d) plasma polymerization of a second fluorohydrocarbon and deposition of the resulting polymer onto the polymer formed in step (c), then (e) plasma polymerization of a third compound of formula (I) and deposition of the resulting polymer onto the polymer formed in step (d), and then (f) plasma polymerization of a third fluorohydrocarbon and deposition of the resulting polymer onto the polymer formed in step (e). The compound of formula (I) and fluorohydrocarbon are preferably as defined below, and more preferably are 1,4-dimethylbenzene and hexafluoropropylene (C₃F₆).

A further particularly preferred conformal coating of the present invention comprises eight layers. This conformal coating is obtainable by (a) plasma polymerization of a first compound of formula (I) and deposition of the resulting polymer onto at least one surface of the electrical assembly, then (b) plasma polymerization of a first fluorohydrocarbon and deposition of the resulting polymer onto the polymer formed in step (a), then (c) plasma polymerization of a second compound of formula (I) and deposition of the resulting polymer onto the polymer formed in step (b), then (d) plasma polymerization of a second fluorohydrocarbon and deposition of the resulting polymer onto the polymer formed in step (c), then (e) plasma polymerization of a third compound of formula (I) and deposition of the resulting polymer onto the polymer formed in step (d), then (f) plasma polymerization of a third fluorohydrocarbon and deposition of the resulting polymer onto the polymer formed in step (e), then (g) plasma polymerization of a fourth compound of formula (I) and deposition of the resulting polymer onto the polymer formed in step (f), and then (h) plasma polymerization of a fourth fluorohydrocarbon and deposition of the resulting polymer onto the polymer formed in step (g). The compound of formula (I) and fluorohydrocarbon are preferably as defined below, and more preferably are 1,4-dimethylbenzene and hexafluoropropylene (C₃F₆).

Another particularly preferred conformal coating of the present invention comprises three layers. This conformal coating is obtainable by (i) plasma polymerization of a first fluorohydrocarbon of formula (I) and deposition of the resulting polymer onto at least one surface of the electrical assembly, then (ii) plasma polymerization of a compound of formula (I) and deposition of the resulting polymer onto the polymer formed in step (i), and then (iii) plasma polymerization of a second fluorohydrocarbon and deposition of the resulting polymer onto the polymer formed in step (ii). The compound of formula (I) and fluorohydrocarbon are preferably as defined below, and more preferably are 1,4-dimethylbenzene and hexafluoropropylene (C₃F₆).

Another particularly preferred conformal coating of the present invention comprises five layers. This conformal coating is obtainable by (i) plasma polymerization of a first fluorohydrocarbon of formula (I) and deposition of the resulting polymer onto at least one surface of the electrical assembly, then (ii) plasma polymerization of a first compound of formula (I) and deposition of the resulting polymer onto the polymer formed in step (i), and then (iii) plasma polymerization of a second fluorohydrocarbon and deposition of the resulting polymer onto the polymer formed in step (ii), then (iv) plasma polymerization of a second compound of formula (I) and deposition of the resulting polymer onto the polymer formed in step (iii), and then (v) plasma polymerization of a third fluorohydrocarbon and deposition of the resulting polymer onto the polymer formed in step (iv). The compound of formula (I) and fluorohydrocarbon are preferably as defined below, and more preferably are 1,4-dimethylbenzene and hexafluoropropylene (C₃F₆).

The thickness of the conformal coating of the present invention will depend upon the number of layers of each polymer that are deposited. The or each layer obtainable by plasma polymerization of a compound of formula (I) typically has a mean-average thickness of 250 to 350 nm, preferably 275 to 325 nm, for example about 300 nm. The or each layer obtainable by plasma polymerization of a fluorohydrocarbon typically has a mean-average thickness of 25 to 100 nm, preferably 50 to 75 nm.

Thus, if the conformal coating of the invention has one layer obtainable by plasma polymerization of a compound of formula (I) and one layer obtainable by plasma polymerization of a fluorohydrocarbon, then typically the mean-average thickness of the conformal coating is 275 to 450 nm, preferably 325 to 400 nm.

Similarly, if the conformal coating of the invention has two layers obtainable by plasma polymerization of a compound of formula (I) and two layers obtainable by plasma polymerization of a fluorohydrocarbon, then typically the mean-average thickness of the conformal coating is 550 to 900 nm, preferably 650 to 800 nm.

The thickness of each layer can be easily controlled by a skilled person. Plasma polymerization deposits the polymer at a uniform rate, and thus the thickness of a layer of polymer deposited is proportional to the deposition time. Accordingly, once the rate of deposition has been determined, a layer with a specific thickness can be deposited by controlling the duration of deposition.

The thickness of the conformal coating may be substantially uniform or may vary from point to point.

Precursor compounds of formula (I) have the following structure: 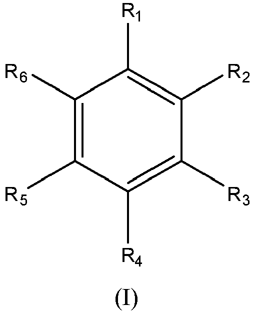 wherein R₁ represents C₁-C₃ alkyl or C₂-C₃ alkenyl; R₂ represents hydrogen, C₁-C₃ alkyl or C₂-C₃ alkenyl; R₃ represents hydrogen, C₁-C₃ alkyl or C₂-C₃ alkenyl; R₄ represents hydrogen, C₁-C₃ alkyl or C₂-C₃ alkenyl; R₅ represents hydrogen, C₁-C₃ alkyl or C₂-C₃ alkenyl; and R₆ represents hydrogen, C₁-C₃ alkyl or C₂-C₃ alkenyl.

As used herein, the term C₁-C₃ alkyl embraces a linear or branched hydrocarbon radical having 1 to 3, preferably 1 to 2 carbon atoms. Examples include methyl, ethyl, n-propyl and i-propyl.

As used herein, the term C₂-C₃ alkenyl embraces a linear or branched hydrocarbon radical having 2 or 3 carbon atoms and a carbon-carbon double bond. A preferred example is vinyl.

Typically, R₁ represents methyl or vinyl. Typically, R₂ represents hydrogen, methyl or vinyl. Typically, R₃ represents hydrogen, methyl or vinyl. Typically, R₄ represents hydrogen, methyl or vinyl. Typically, R₅ represents hydrogen, methyl or vinyl, preferably hydrogen. Typically, R₆ represents hydrogen, methyl or vinyl, preferably hydrogen.

Preferably, R₅ and R₆ represent hydrogen.

More preferably, R₁ represents methyl or vinyl, R₂ represents hydrogen, methyl or vinyl, R₃ represents hydrogen, methyl or vinyl, R₄ represents hydrogen, methyl or vinyl, R₅ represents hydrogen and R₆ represents hydrogen.

It is generally preferred that two of R₂ to R₄ represent hydrogen.

Preferred compounds of formula (I) are 1,4-dimethylbenzene, 1,3-dimethylbenzene, 1,2-dimethylbenzene, toluene, 4-methyl styrene, 3-methyl styrene, 2-methyl styrene, 1,4-divinyl benzene, 1,3-divinyl benzene or 1,2-divinyl benzene. 1,4-dimethylbenzene is particularly preferred.

A fluorohydrocarbon is a hydrocarbon material comprising fluorine atoms. Preferred fluorohydrocarbons are perfluoroalkanes, perfluoroalkenes, perfluoroalkynes, fluoroalkanes, fluoroalkenes and fluoroalkynes, wherein said compounds preferably contain up to 10 carbon atoms, more preferably up to five carbon atoms. Preferred examples include CF₄, C₂F₄, C₂F₆, C₃F₆, C₃F₈ and C₄F₈. A most preferred fluorohydrocarbon is hexafluoropropylene (C₃F₆).

It is particularly preferred that the or each compound of formula (I) is 1,4-dimethylbenzene, 1,3-dimethylbenzene, 1,2-dimethylbenzene, toluene, 4-methyl styrene, 3-methyl styrene, 2-methyl styrene, 1,4-divinyl benzene, 1,3-divinyl benzene or 1,2-divinyl benzene, and the or each fluorohydrocarbon is CF₄, C₂F₄, C₂F₆, C₃F₆, C₃F₈ or C₄F₈. A particularly preferred combination is 1,4-dimethylbenzene and hexafluoropropylene (C₃F₆).

Typically, the conformal coating comprises a first layer obtainable by plasma polymerization and deposition of a fluorohydrocarbon or compound of formula (I) and a second layer obtainable by plasma polymerization and deposition of a fluorohydrocarbon or compound of formula (I), wherein the refractive index of the first layer is different from the refractive index of the second layer. The conformal coating may comprise more than two layers, provided that at least two of those layers have different refractive indexes. Preferably the two layers with different refractive index are adjacent to each other in the conformal coating.

When there is a difference in refractive index between two layers and light is directed onto an electrical assembly with the conformal coating from behind the eye of an observer, then optical interference of that light will occur. A particular colour will thus be seen by the observer on areas where the conformal coating is present. This provides a simple and efficient method for determining whether a particular electrical assembly has a conformal coating or not. This is important in the electronics industry, since thin film conformal coatings are generally virtually invisible.

The exact colour observed will depend on a number of factors, including the magnitude of the difference in refractive index, the thicknesses of the layers within the conformal coating and the specific conditions under which light is directed onto the conformal coating.

Preferably, the difference in refractive index between the two layers is greater than 0.01, more preferably greater than 0.1, more preferably between 0.2 and 0.4, for example around 0.3. The refractive index of a given layer can be measured using techniques known to those skilled in the art. Ellipsometry and reflectometry are typically used to determine refractive index, with ellipsometry preferred. A specific method using an ellipsometer is described in the Examples below, though any suitable technique can be used.

Preferably, the thickness of at least one of the two layers is from 195z/y nm to 375z/y nm, wherein z is an integer and y is the refractive index of the layer. Preferably z is 1 to 5, more preferably 1 to 3, for example 1 or 2. When the thickness satisfies this expression, then visible light with a wavelength of from 390 to 750nm is reflected by the conformal coating. The coating will thus be visible to the human eye.
Preferably, light is directed onto the conformal coating at an angle of 90° (ie. normal) to the surface of the conformally coated electrical assembly. Preferably a fluorescent lamp or tube is used as a light source. The electrical assembly typically comprises a substrate comprising an insulating material, a plurality (ie. at least one) of conductive tracks present on least one surface of the substrate, and at least one electrical component connected to at least one conductive track. The conformal coating thus typically covers the surface of the substrate on which the plurality of conductive tracks are present, the plurality of conductive tracks and the at least one electrical component.

An electrically conductive track typically comprises any suitable electrically conductive material. Preferably, an electrically conductive track comprises gold, tungsten, copper, silver, aluminium, doped regions of semi-conductor substrates, conductive polymers and/or conductive inks. More preferably, an electrically conductive track comprises gold, tungsten, copper, silver or aluminium.

Suitable shapes and configurations for the conductive tracks can be selected by a person skilled in the art for the particular assembly in question. Typically, an electrically conductive track is attached to the surface of the substrate along its entire length. Alternatively, an electrically conductive track may be attached to the substrate at two or more points. For example, an electrically conductive track may be a wire attached to the substrate at two or more points, but not along its entire length.

An electrically conductive track is typically formed on a substrate using any suitable method known to those skilled in the art. In a preferred method, electrically conductive tracks are formed on a substrate using a "subtractive" technique. Typically in this method, a layer of metal (e.g., copper foil, aluminium foil, etc.) is bonded to a surface of the substrate and then the unwanted portions of the metal layer are removed, leaving the desired conductive tracks. The unwanted portions of the metal layer are typically removed from the substrate by chemical etching or photo-etching, milling. In an alternative preferred method, conductive tracks are formed on the substrate using an "additive" technique such as, for example, electroplating, deposition using a reverse mask, and/or any geometrically controlled deposition process. Alternatively, the substrate may be a silicon die or wafer, which typically has doped regions as the conductive tracks.

The substrate typically comprises any suitable insulating material that prevents the substrate from shorting the circuit of electrical assembly. The substrate preferably comprises an epoxy laminate material, a synthetic resin bonded paper, an epoxy resin bonded glass fabric (ERBGH), a composite epoxy material (CEM), PTFE (Teflon), or other polymer materials, phenolic cotton paper, silicon, glass, ceramic, paper, cardboard, natural and/or synthetic wood based materials, and/or other suitable textiles. The substrate optionally further comprises a flame retardant material, typically Flame Retardant 2 (FR-2) and/or Flame Retardant 4 (FR-4). The substrate may comprise a single layer of an insulating material or multiple layers of the same or different insulating materials. The substrate may be the board of a printed circuit board (PCB) made of any one of the materials listed above.

An electrical component may be any suitable circuit element of an electrical assembly. Preferably, an electrical component is a resistor, capacitor, transistor, diode, amplifier, antenna or oscillator. Any suitable number and/or combination of electrical components may be connected to the electrical assembly.

The electrical component is preferably connected to an electrically conductive track via a bond. The bond is preferably a solder joint, a weld joint, a wire-bond joint, a conductive adhesive joint, a crimp connection, or a press-fit joint. Suitable soldering, welding, wire-bonding, conductive adhesive and press-fit techniques are known to those skilled in the art, for forming the bond. More preferably the bond is a solder joint, a weld joint or a wire-bond joint, with a solder joint most preferred.

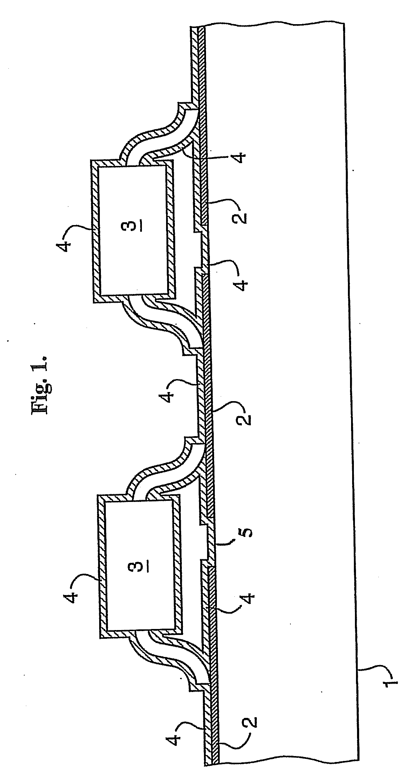

Aspects of the invention will now be described with reference to the embodiment shown in Figures 1 to 3, in which like reference numerals refer to the same or similar components.

Figure 1 shows an example of an electrical assembly of the invention. The electrical assembly comprises a substrate **1** comprising an insulating material, a plurality of conductive tracks **2** present on least one surface of the substrate **1,** and at least one electrical component **3** connected to at least one conductive track **2.** The conformal coating **4** covers the plurality of conductive tracks **2,** the at least one electrical component **3** and the surface **5** of the substrate **1** on which the plurality of conductive tracks and the at least one electrical component are located.

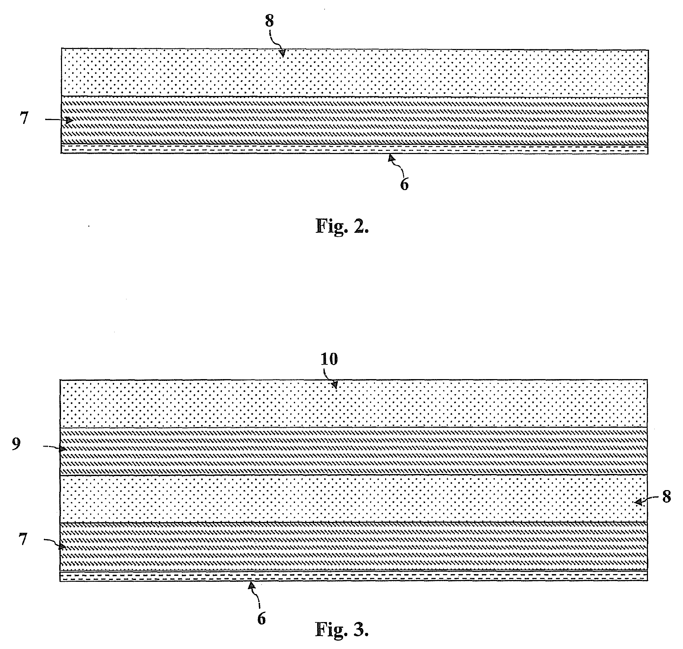

Figure 2 shows a cross section through a preferred example of the conformal coating **4** in Figure 1. The conformal coating comprises a first polymer 7 obtainable by plasma polymerization of a compound of formula (I) and deposition of the resulting polymer onto at least one surface **6** of the electrical assembly, and a second polymer **8** obtainable plasma polymerization of a fluorohydrocarbon and deposition of the resulting polymer onto the polymer **7.**

Figure 3 shows a cross section through another preferred example of the conformal coating **4** in Figure 1. The conformal coating comprises a first polymer **7** obtainable by plasma polymerization of a first compound of formula (I) and deposition of the resulting polymer onto at least one surface **6** of the electrical assembly, a second polymer **8** obtainable by plasma polymerization of a first fluorohydrocarbon and deposition of the resulting polymer onto the polymer **7,** a third polymer **9** obtainable by plasma polymerization of a second compound of formula **(I)** and deposition of the resulting polymer onto the polymer **8,** and a fourth polymer **10** obtainable by plasma polymerization of a second fluorohydrocarbon and deposition of the resulting polymer onto the polymer **9.**

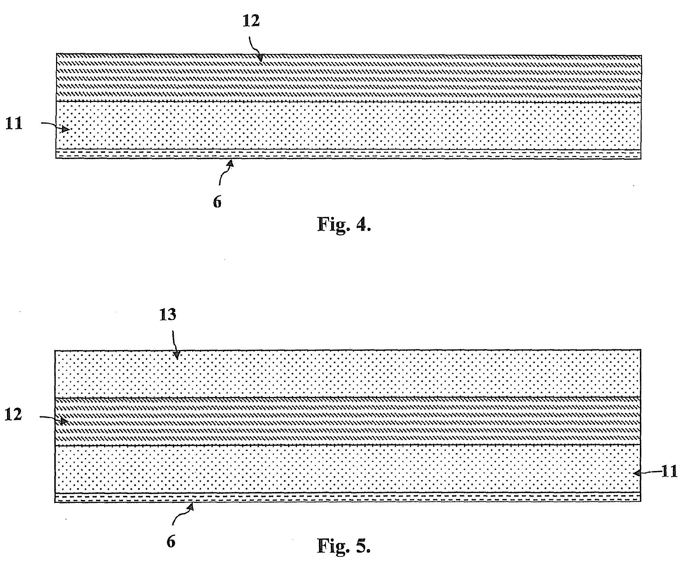

Figure 4 shows a cross section through a preferred example of the conformal coating **4** in Figure 1. The conformal coating comprises a first polymer **11** obtainable by plasma polymerization of a fluorohydrocarbon and deposition of the resulting polymer onto at least one surface 6 of the electrical assembly, and a second polymer **12** obtainable plasma polymerization of a compound of formula **(I)** and deposition of the resulting polymer onto the polymer **11.**

Figure 5 shows a cross section through another preferred example of the conformal coating **4** in Figure 1. The conformal coating comprises a first polymer **11** obtainable by plasma polymerization of a first fluorohydrocarbon and deposition of the resulting polymer onto at least one surface **6** of the electrical assembly, a second polymer **12** obtainable by plasma polymerization of a compound of formula (I) and deposition of the resulting polymer onto the polymer **11,** and a third polymer **13** obtainable by plasma polymerization of a second fluorohydrocarbon and deposition of the resulting polymer onto the polymer **12.**

Aspects of the invention will now be described with reference to the Examples

### Examples

### Example 1

An electrical assembly to be coated was placed into a plasma deposition chamber and the atmosphere was evacuated to 50 mTorr. 1,4-dimethylbenzene vapour was then introduced to the chamber at a flow rate of approximately 10sccm using a mass flow controller. The RF generator was switched on at a power of 175W and a plasma was formed. The 1,4-dimethylbenzene was ionized and then reacted with itself to form a continuous and conformal coating on the electrical assembly. Once the desired coating thickness had formed, the RF generator was switched off and the flow of 1,4-dimethylbenzene was stopped.

The chamber was brought to atmospheric pressure and opened and the electrical assembly with a conformal coating was removed.

### Example 2

An electrical assembly to be coated was placed into a plasma deposition chamber and the atmosphere was evacuated to 50 mTorr. 1,4-dimethylbenzene vapour was then introduced to the chamber at a flow rate of approximately 10sccm using a mass flow controller. The RF generator was switched on at a power of 175W and a plasma was formed. The 1,4-dimethylbenzene was ionized and then reacted with itself to form a continuous and conformal coating on the electrical assembly. Once the desired coating thickness had formed, the RF generator was switched off and the flow of 1,4-dimethylbenzene was stopped.

The vacuum in the chamber was maintained and hexafluoropropylene gas was then introduced to the chamber at a specific flow rate which was controlled at approximately 5sccm using a mass flow controller. The RF generator was switched on at a power of 175W and a plasma was formed. The hexafluoropropylene was ionized and then reacted with itself to form a continuous and conformal coating on the previous coating. Once the desired coating thickness had formed, the RF generator was switched off and the flow of hexafluoropropylene was stopped.

The chamber was brought to atmospheric pressure and opened and the electrical assembly with a conformal coating was removed.

### Example 3

An electrical assembly to be coated was placed into a plasma deposition chamber and the atmosphere was evacuated to 50 mTorr. 1,4-dimethylbenzene vapour was then introduced to the chamber at a flow rate of approximately 10sccm using a mass flow controller. The RF generator was switched on at a power of 175W and a plasma was formed. The 1,4-dimethylbenzene was ionized and then reacted with itself to form a continuous and conformal coating on the electrical. Once the desired coating thickness had formed, the RF generator was switched off and the flow of paraxylene was stopped.

The vacuum in the chamber was maintained and hexafluoropropylene gas was then introduced to the chamber at a flow rate of approximately 5sccm using a mass flow controller. The RF generator was switched on at a power of 175W and a plasma was formed. The hexafluoropropylene was ionized and then reacted with itself to form a continuous and conformal coating on the previous coating. Once the desired coating thickness had formed, the RF generator was switched off and the flow of hexafluoropropylene was stopped.

While maintaining the vacuum, two further layers were added, the first from 1,4-dimethylbenzene and the second from hexafluoropropylene, using the same methods as described above.

The chamber was brought to atmospheric pressure and opened and the electrical assembly with a conformal coating removed.

### Example 4

An electrical assembly to be coated was placed into a plasma deposition chamber and the atmosphere was evacuated to 50 mTorr. Hexafluoropropylene gas was then introduced to the chamber at a flow rate of approximately 5sccm using a mass flow controller. The RF generator was switched on at a power of 175W and a plasma was formed. The hexafluoropropylene was ionized and then reacted with itself to form a continuous and conformal coating on the electrical assembly. Once the desired coating thickness had formed, the RF generator was switched off and the flow of hexafluoropropylene was stopped.

The vacuum in the chamber was maintained and 1,4-dimethylbenzene vapour was then introduced to the chamber at a flow rate of approximately 10sccm using a mass flow controller. The RF generator was switched on at a power of 175W and a plasma was formed. The paraxylene was ionized and then reacted with itself to form a continuous and conformal coating on the previous coating. Once the desired coating thickness had formed, the RF generator was switched off and the flow of 1,4-dimethylbenzene was stopped.

The vacuum in the chamber was maintained and hexafluoropropylene gas was then introduced to the chamber at a flow rate of 5sccm using a mass flow controller. The RF generator was switched on at a power of 175W and a plasma was formed. The hexafluoropropylene was ionized and then reacted with itself to form a continuous and conformal coating on the previous coating. Once the desired coating thickness had formed, the RF generator was switched off and the flow of hexafluoropropylene was stopped.

The chamber was brought to atmospheric pressure and opened and the electrical assembly with a conformal coating removed.

### Example 5

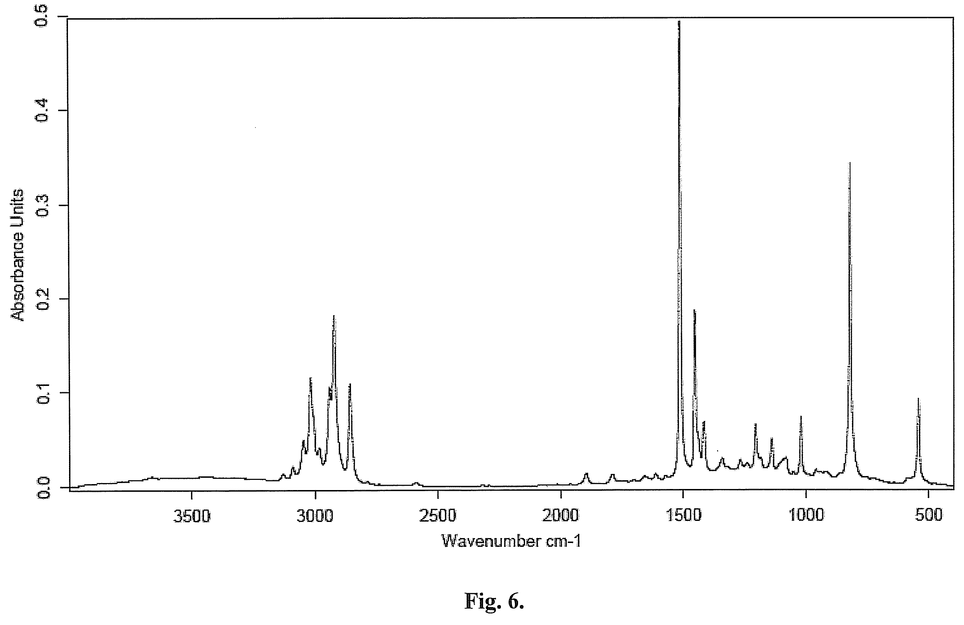

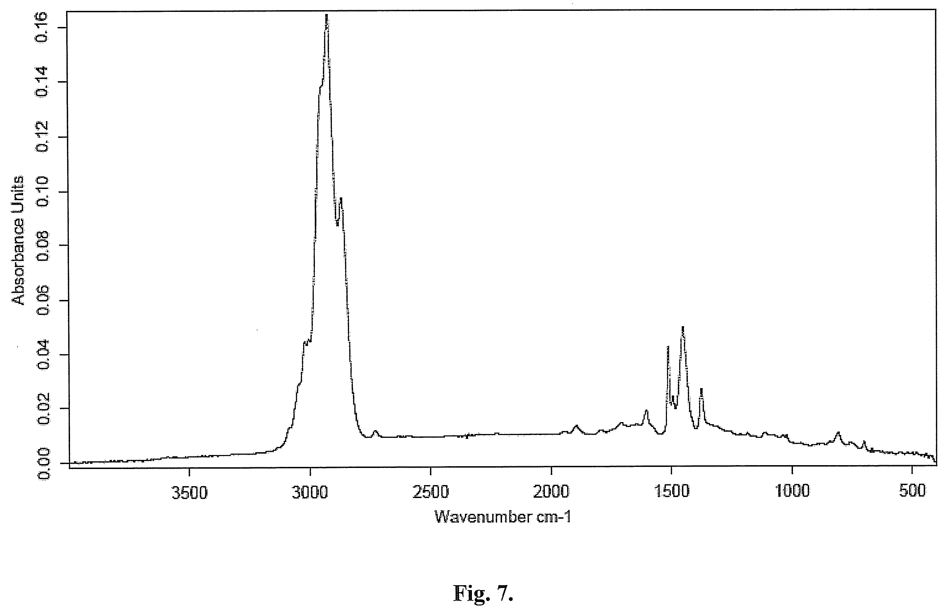

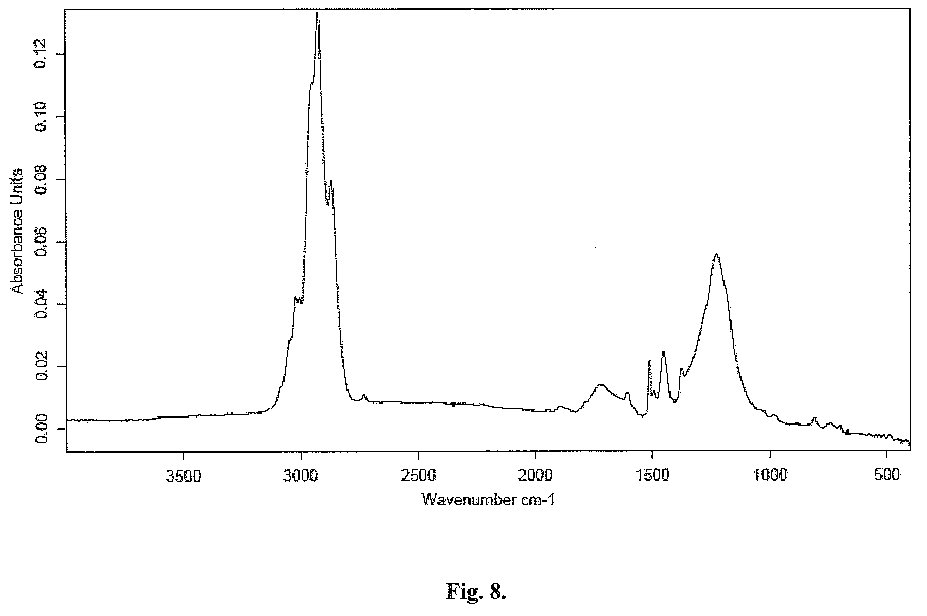

Fourier transform infrared (FTIR) spectroscopy was carried out on the following conformal coatings:
1. A conventional parylene conformal coating. The spectrum is shown in Figure 6.
2. The conformal coating prepared in Example 1 above, by plasma polymerization of 1,4-dimethylbenzene. The spectrum is shown in Figure 7.
3. The multilayer coatings prepared in Examples 2 to 4, which contain plasma polymerized 1,4-dimethylbenzene and plasma polymerized hexafluoropropylene. The spectrum is shown in Figure 8.

Figures 6 to 8 highlight how the coating obtainable by plasma polymerization of 1,4-dimethylbenzene is different from conventional parylene.

Parylene is a polymer with a regular, well defined structure which gives rise to sharp peaks in the spectrum of Figure 6. Of particular interest is the cluster of peaks centred around 3000cm⁻¹. The peaks to the right of 3000cm⁻¹ represent the aliphatic C-H stretches, while those to the left are the aromatic C-H stretches due to the hydrogen atoms attached to the benzene ring.

Figure 7 shows that plasma polymerized 1,4-dimethylbenzene is less well defined than parylene, as is characteristic of plasma polymers in general. This results in peaks which are broader, and less sharp. Additionally, the ratio of aromatic to aliphatic C-H stretches has changed considerably, because some of the ring structure in the 1,4-dimethylbenzene precursor has been lost.

As expected, Figure 8 contains peaks similar to those in Figure 7. An additional absorption at around 1200cm⁻¹ is observed, which is due to the C-F stretch in the plasma polymerized hexafluoropropylene.

### Example 6

Test electrical assemblies were coated with alternating layers of plasma polymerized 1,4-dimethylbenzene (denoted PDMB in Table 1) and plasma polymerized hexafluoropropylene (denoted PHFP in Table 1), using the same methods as described above in Examples 1 to 4. The final coatings deposited are set out in Table 1 below, with Layer 1 representing the first layer deposited onto the assembly.

**Table 1**

| **Coating** | **Layer 1** | **Layer 2** | **Layer 3** | **Layer 4** | **Layer 5** | **Layer 6** |
|---|---|---|---|---|---|---|
| 1 | 900nm PDMB | Not present | Not present | Not present | Not present | Not present |
| 2 | 50nm PHFP | Not present | Not present | Not present | Not present | Not present |
| 3 | 900nm of PDMB | 50nm of PHFP | Not present | Not present | Not present | Not present |
| 4 | 300nm of PDMB | 50nm of PHFP | 300nm of PDMB | 50nm of PHFP | Not present | Not present |
| 5 | 300nm of PDMB | 50nm of PHFP | 300nm of PDMB | 50nm of PHFP | 300nm of PDMB | 50nm of PHFP |

The performance of each coating was tested under the following conditions. A 2V potential was applied across the coated assemblies, which were immersed in 10g/l salt solution. A failure was recorded when the current leakage across the coating reached 100µA. Multiple assemblies with Coatings 1 to 5 were tested, so that a mean time to failure could be determined. These results are set out in Table 2.

**Table 2**

| **Coating** | **Mean time to failure (minutes)** |
|---|---|
| 1 | 225 |
| 2 | 81 |
| 3 | 1422 |
| 4 | 2647 |
| 5 | 2880 |

The two layer structure of Coating 3 achieved significantly better performance than not only the single layer structures of Coatings 1 and 2, but also than the performance that would be expected from the two layer structure based on the results with Coatings 1 and 2.

A further improvement in performance was achieved by using the four layer structure of Coating 4, as compared with Coating 3, despite the overall thickness of Coating 3 being greater. Similarly, an additional repeating unit as found in Coating 5 provide yet further improvement in performance over Coating 3.

Coatings 3 to 5 achieved excellent results under the test conditions, indicating that these coatings would perform well as conformal coatings.

### Example 7

Three layer coatings were applied to electrical assemblies using the procedure set out in Example 4. The layers were of plasma polymerized 1,4-dimethylbenzene (denoted PDMB in Table 1) and plasma polymerized hexafluoropropylene (denoted PHFP in Table 1). The coatings set out in Table 3 were applied. The colour observed when each coated electrical assembly was illuminated by a fluorescent light behind the observers eye is also set out in the table below. The presence of the conformal coating was thus easily confirmed, as compared to the uncoated assembly, which was green.

**Table 3**

| **Coating** | **Layer 1** | **Layer 2** | **Layer 3** | **Colour** |
|---|---|---|---|---|
| 6 | 40nm of PHFP | 170nm ofPDMB | 40nm of PHFP | Blue |
| 7 | 40nm of PHFP | 300nm ofPDMB | 40nm of PHFP | Purple |
| 8 | 40nm of PHFP | 680nm ofPDMB | 40nm of PHFP | Pink |
| None (uncoated) | - | - | - | Green |

### Example 8

Samples of plasma polymerized 1,4-dimethylbenzene and plasma polymerized hexafluoropropylene were deposited on gold-coated glass slides in accordance with the procedures described in Examples 1 to 4.

Spectroscopic ellipsometry was carried out on the samples using a Woollam M 2000 DI ellipsometer. A wavelength range of 192 nm to 1700 nm and three incidence angles of 65°, 70°, and 75° normal to the surface were used for all samples. Multiple points were measured on each sample and a Cauchy model was created for each material. Analysis of the resultant model was used to calculate the thickness and refractive index of the materials used.

The refractive index of the plasma polymerized 1,4-dimethylbenzene was found to be 1.592. The refractive index of the plasma polymerized hexafluoropropylene was found to be 1.375.

## Claims

1. An electrical assembly which has a conformal coating, wherein said conformal coating is obtainable by a method which comprises:
(a) plasma polymerization of a compound of formula (I) and deposition of the resulting polymer onto at least one surface of the electrical assembly: 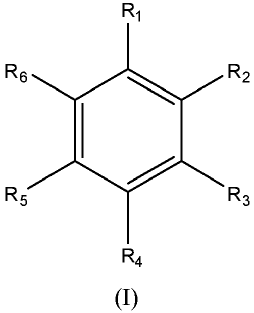 wherein:
R₁ represents C₁-C₃ alkyl or C₂-C₃ alkenyl;
R₂ represents hydrogen, C₁-C₃ alkyl or C₂-C₃ alkenyl;
R₃ represents hydrogen, C₁-C₃ alkyl or C₂-C₃ alkenyl;
R₄ represents hydrogen, C₁-C₃ alkyl or C₂-C₃ alkenyl;
R₅ represents hydrogen, C₁-C₃ alkyl or C₂-C₃ alkenyl; and
R₆ represents hydrogen, C₁-C₃ alkyl or C₂-C₃ alkenyl, and
(b) plasma polymerization of a fluorohydrocarbon and deposition of the resulting polymer onto the polymer formed in step (a).

2. An electrical assembly which has a conformal coating, wherein said conformal coating is obtainable by a method which comprises:
(i) plasma polymerization of a fluorohydrocarbon and deposition of the resulting polymer onto at least one surface of the electrical assembly, and
(ii) plasma polymerization of a compound of formula (I) as defined in claim 1 and deposition of the resulting polymer onto the polymer formed in step (i).

3. An electrical assembly according claim 1, wherein said conformal coating is obtainable by a method which comprises:
(a) plasma polymerization of a first compound of formula (I) and deposition of the resulting polymer onto at least one surface of the electrical assembly,
(b) plasma polymerization of a first fluorohydrocarbon and deposition of the resulting polymer onto the polymer formed in step (a),
(c) plasma polymerization of a second compound of formula (I) and deposition of the resulting polymer onto the polymer formed in step (b), and
(d) plasma polymerization of a second fluorohydrocarbon and deposition of the resulting polymer onto the polymer formed in step (c).

4. An electrical assembly according claim 2, wherein said conformal coating is obtainable by a method which comprises:
(i) plasma polymerization of a first fluorohydrocarbon and deposition of the resulting polymer onto at least one surface of the electrical assembly,
(ii) plasma polymerization of a compound of formula (I) and deposition of the resulting polymer onto the polymer formed in step (i), and
(iii) plasma polymerization of a second fluorohydrocarbon and deposition of the resulting polymer onto the polymer formed in step (ii).

5. An electrical assembly according to any one of the preceding claims, wherein the or each compound of formula (I) is 1,4-dimethylbenzene, 1,3-dimethylbenzene, 1,2-dimethylbenzene, toluene, 4-methyl styrene, 3-methyl styrene, 2-methyl styrene, 1,4-divinyl benzene, 1,3-divinyl benzene or 1,2-divinyl benzene.

6. An electrical assembly according any one of the preceding claims, wherein the or each fluorohydrocarbon is CF₄, C₂F₄, C₂F₆, C₃F₆, C₃F₈ or C₄F₈.

7. An electrical assembly according any one of the preceding claims wherein the or each compound of formula (I) is 1,4-dimethylbenzene and the or each fluorohydrocarbon is C₃F₆.

8. An electrical assembly according to any one of the preceding claims which comprises a substrate comprising an insulating material, a plurality of conductive tracks present on least one surface of the substrate, and at least one electrical component connected to at least one conductive track.

9. An electrical assembly according to claim 8, wherein the conformal coating covers the plurality of conductive tracks, the at least one electrical component and the surface of the substrate on which the plurality of conductive tracks and the at least one electrical component are located.

10. A method for conformally coating an electrical assembly, which method comprises:
(a) plasma polymerization of a compound of formula (I) as defined in claim 1 and deposition of the resulting polymer onto at least one surface of the electrical assembly, and
(b) plasma polymerization of a fluorohydrocarbon and deposition of the resulting polymer onto the polymer formed in step (a).

11. A method for conformally coating an electrical assembly, which method comprises:
(i) plasma polymerization of a fluorohydrocarbon and deposition of the resulting polymer onto at least one surface of the electrical assembly, and
(ii) plasma polymerization of a compound of formula (I) as defined in claim 1 and deposition of the resulting polymer onto the polymer formed in step (i).

12. A method according to claim 10, which method comprises:
(a) plasma polymerization of a first compound of formula (I) and deposition of the resulting polymer onto at least one surface of the electrical assembly,
(b) plasma polymerization of a first fluorohydrocarbon and deposition of the resulting polymer onto the polymer formed in step (a),
(c) plasma polymerization of a second compound of formula (I) and deposition of the resulting polymer onto the polymer formed in step (b), and
(d) plasma polymerization of a second fluorohydrocarbon and deposition of the resulting polymer onto the polymer formed in step (c).

13. A method according to claim 11, which method comprises:
(i) plasma polymerization of a first fluorohydrocarbon and deposition of the resulting polymer onto at least one surface of the electrical assembly,
(ii) plasma polymerization of a compound of formula (I) and deposition of the resulting polymer onto the polymer formed in step (i), and
(iii) plasma polymerization of a second fluorohydrocarbon and deposition of the resulting polymer onto the polymer formed in step (ii).

14. A method according to any one of claims 10 to 13, in which the electrical assembly comprises a substrate comprising an insulating material, a plurality of conductive tracks present on least one surface of the substrate, and at least one electrical component connected to at least one conductive track.

15. A method according to claim 14, which comprises plasma polymerization of a compound of formula (I) and deposition of the resulting polymer onto the plurality of conductive tracks, the at least one electrical component and the surface of the substrate on which the plurality of conductive tracks and the at least one electrical component are located.

## Patentansprüche

1. Elektrische Baugruppe, die eine konforme Beschichtung aufweist, wobei die konforme Beschichtung durch ein Verfahren erhältlich ist, das umfasst:
(a) Plasmapolymerisieren einer Verbindung der Formel (I) und Abscheiden des entstehenden Polymers auf zumindest eine Oberfläche der elektrischen Baugruppe: 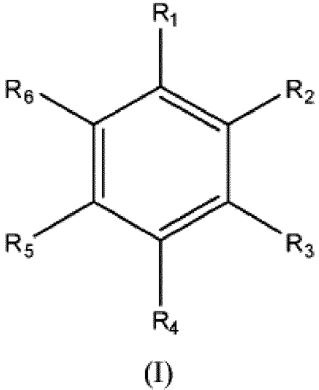 wobei:
R₁ C₁-C₃-Alkyl oder C₂-C₃-Alkenyl darstellt;
R₂ Wasserstoff, C₁-C₃-Alkyl oder C₂-C₃-Alkenyl darstellt;
R₃ Wasserstoff, C₁-C₃-Alkyl oder C₂-C₃-Alkenyl darstellt;
R₄ Wasserstoff, C₁-C₃-Alkyl oder C₂-C₃-Alkenyl darstellt;
R₅ Wasserstoff, C₁-C₃-Alkyl oder C₂-C₃-Alkenyl darstellt; und
R₆ Wasserstoff, C₁-C₃-Alkyl oder C₂-C₃-Alkenyl darstellt, und
(b) Plasmapolymerisieren eines Fluorkohlenwasserstoffs und Abscheiden des entstehenden Polymers auf das in Schritt (a) gebildete Polymer.

2. Elektrische Baugruppe, die eine konforme Beschichtung aufweist, wobei die konforme Beschichtung durch ein Verfahren erhältlich ist, das umfasst:
(i) Plasmapolymerisieren eines Fluorkohlenwasserstoffs und Abscheiden des entstehenden Polymers auf zumindest eine Oberfläche der elektrischen Baugruppe, und
(ii) Plasmapolymerisieren einer Verbindung der Formel (I), wie in Anspruch 1 definiert, und Abscheiden des entstehenden Polymers auf das in Schritt (i) gebildete Polymer.

3. Elektrische Baugruppe nach Anspruch 1, wobei die konforme Beschichtung durch ein Verfahren erhältlich ist, das umfasst:
(a) Plasmapolymerisieren einer ersten Verbindung der Formel (I) und Abscheiden des entstehenden Polymers auf zumindest eine Oberfläche der elektrischen Baugruppe,
(b) Plasmapolymerisieren eines ersten Fluorkohlenwasserstoffs und Abscheiden des entstehenden Polymers auf das in Schritt (a) gebildete Polymer,
(c) Plasmapolymerisieren einer zweiten Verbindung der Formel (I) und Abscheiden des entstehenden Polymers auf das in Schritt (b) gebildete Polymer, und
(d) Plasmapolymerisieren eines zweiten Fluorkohlenwasserstoffs und Abscheiden des entstehenden Polymers auf das in Schritt (c) gebildete Polymer,

4. Elektrische Baugruppe nach Anspruch 2, wobei die konforme Beschichtung durch ein Verfahren erhältlich ist, das umfasst:
(i) Plasmapolymerisieren eines ersten Fluorkohlenwasserstoffs und Abscheiden des entstehenden Polymers auf zumindest eine Oberfläche der elektrischen Baugruppe,
(ii) Plasmapolymerisieren einer Verbindung der Formel (I) und Abscheiden des entstehenden Polymers auf das in Schritt (i) gebildete Polymer, und
(iii) Plasmapolymerisieren eines zweiten Fluorkohlenwasserstoffs und Abscheiden des entstehenden Polymers auf das in Schritt (ii) gebildete Polymer.

5. Elektrische Baugruppe nach einem der vorstehenden Ansprüche, wobei die oder jede Verbindung der Formel (I) 1,4-Dimethylbenzol, 1,3-Dimethylbenzol, 1,2-Dimethylbenzol, Toluol, 4-Methylstyrol, 3-Methylstyrol, 2-Methylstyrol, 1,4-Divinylbenzol, 1,3-Divinylbenzol oder 1,2-Divinylbenzol ist.

6. Elektrische Baugruppe nach einem der vorstehenden Ansprüche, wobei der oder jeder Fluorkohlenwasserstoff CF₄, C₂F₄, C₂F₆, C₃F₆, C₃F₈ oder C₄F₈ ist.

7. Elektrische Baugruppe nach einem der vorstehenden Ansprüche, wobei die oder jede Verbindung der Formel (I) 1,4-Dimethylbenzol ist und der oder jede Fluorkohlenwasserstoff C₃F₆ ist.

8. Elektrische Baugruppe nach einem der vorstehenden Ansprüche, die ein Substrat umfasst, das ein Isoliermaterial, eine Mehrzahl von Leiterbahnen, die auf einer Oberfläche des Substrats vorhanden sind, und zumindest eine elektrische Komponente umfasst, die mit zumindest einer Leiterbahn verbunden ist.

9. Elektrische Baugruppe nach Anspruch 8, wobei die konforme Beschichtung die Mehrzahl von Leiterbahnen, die zumindest eine elektrische Komponente und die Oberfläche des Substrats, auf der sich die Mehrzahl von Leiterbahnen und die zumindest eine elektrische Komponente befinden, abdeckt.

10. Verfahren zum konformen Beschichten einer elektrischen Baugruppe, wobei das Verfahren umfasst:
(a) Plasmapolymerisieren einer Verbindung der Formel (I), wie in Anspruch 1 definiert, und Abscheiden des entstehenden Polymers auf zumindest eine Oberfläche der elektrischen Baugruppe, und
(b) Plasmapolymerisieren eines Fluorkohlenwasserstoffs und Abscheiden des entstehenden Polymers auf das in Schritt (a) gebildete Polymer.

11. Verfahren zum konformen Beschichten einer elektrischen Baugruppe, wobei das Verfahren umfasst:
(i) Plasmapolymerisieren eines Fluorkohlenwasserstoffs und Abscheiden des entstehenden Polymers auf zumindest eine Oberfläche der elektrischen Baugruppe, und
(ii) Plasmapolymerisieren einer Verbindung der Formel (I), wie in Anspruch 1 definiert, und Abscheiden des entstehenden Polymers auf das in Schritt (i) gebildete Polymer.

12. Verfahren nach Anspruch 10, das umfasst:
(a) Plasmapolymerisieren einer ersten Verbindung der Formel (I) und Abscheiden des entstehenden Polymers auf zumindest eine Oberfläche der elektrischen Baugruppe
(b) Plasmapolymerisieren eines ersten Fluorkohlenwasserstoffs und Abscheiden des entstehenden Polymers auf das in Schritt (a) gebildete Polymer,
(c) Plasmapolymerisieren einer zweiten Verbindung der Formel (I) und Abscheiden des entstehenden Polymers auf das in Schritt (b) gebildete Polymer, und
(d) Plasmapolymerisieren eines zweiten Fluorkohlenwasserstoffs und Abscheiden des entstehenden Polymers auf das in Schritt (c) gebildete Polymer,

13. Verfahren nach Anspruch 11, das umfasst:
(i) Plasmapolymerisieren eines ersten Fluorkohlenwasserstoffs und Abscheiden des entstehenden Polymers auf zumindest eine Oberfläche der elektrischen Baugruppe,
(ii) Plasmapolymerisieren einer Verbindung der Formel (I) und Abscheiden des entstehenden Polymers auf das in Schritt (i) gebildete Polymer, und
(iii) Plasmapolymerisieren eines zweiten Fluorkohlenwasserstoffs und Abscheiden des entstehenden Polymers auf das in Schritt (ii) gebildete Polymer.

14. Verfahren nach einem der Ansprüche 10 bis 13, wobei die elektrische Baugruppe ein Isoliermaterial, eine Mehrzahl von Leiterbahnen, die auf einer Oberfläche des Substrats vorhanden sind, und zumindest eine elektrische Komponente umfasst, die mit zumindest einer Leiterbahn verbunden ist.

15. Verfahren nach Anspruch 14, das das Plasmapolymerisieren einer Verbindung der Formel (I) und das Abscheiden des entstehenden Polymers auf die Mehrzahl von Leiterbahnen, die zumindest eine elektrische Komponente und die Oberfläche des Substrats, auf der sich die Mehrzahl von Leiterbahnen und die zumindest eine elektrische Komponente befinden, abdeckt, umfasst.

## Revendications

1. Ensemble électrique pourvu d'un revêtement conforme, ledit revêtement conforme pouvant être obtenu par un procédé comprenant les étapes suivantes :
(a) polymérisation plasma d'un composé de formule (I) et dépôt du polymère obtenu sur au moins une surface de l'ensemble électrique : 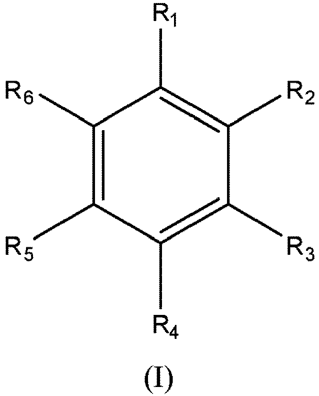 formule (I) dans laquelle :
R₁ représente un alkyle C₁-C₃ ou un alcényle C₂-C₃ ;
R₂ représente un atome d'hydrogène, un alkyle C₁-C₃ ou un alcényle C₂-C₃ ;
R₃ représente un atome d'hydrogène, un alkyle C₁-C₃ ou un alcényle C₂-C₃ ;
R₄ représente un atome d'hydrogène, un alkyle C₁-C₃ ou un alcényle C₂-C₃ ;
R₅ représente un atome d'hydrogène, un alkyle C₁-C₃ ou un alcényle C₂-C₃ ; et
R₆ représente un atome d'hydrogène, un alkyle C₁-C₃ ou un alcényle C₂-C₃ ; et
(b) polymérisation plasma d'un hydrofluorocarbure et dépôt du polymère obtenu sur le polymère formé au cours de l'étape (a).

2. Ensemble électrique pourvu d'un revêtement conforme, ledit revêtement conforme pouvant être obtenu par un procédé comprenant les étapes suivantes :
(i) polymérisation plasma d'un hydrofluorocarbure et dépôt du polymère obtenu sur au moins une surface de l'ensemble électrique, et
(ii) polymérisation plasma d'un composé de formule (I) tel que défini dans la revendication 1 et dépôt du polymère obtenu sur le polymère formé au cours de l'étape (i).

3. Ensemble électrique selon la revendication 1, ledit revêtement conforme pouvant être obtenu par un procédé comprenant les étapes suivantes :
(a) polymérisation plasma d'un premier composé de formule (I) et dépôt du polymère obtenu sur au moins une surface de l'ensemble électrique,
(b) polymérisation plasma d'un premier hydrofluorocarbure et dépôt du polymère obtenu sur le polymère formé au cours de l'étape (a),
(c) polymérisation plasma d'un deuxième composé de formule (I) et dépôt du polymère obtenu sur le polymère formé au cours de l'étape (b), et
(d) polymérisation plasma d'un deuxième hydrofluorocarbure et dépôt du polymère obtenu sur le polymère formé au cours de l'étape (c).

4. Ensemble électrique selon la revendication 2, ledit revêtement conforme pouvant être obtenu par un procédé comprenant les étapes suivantes :
(i) polymérisation plasma d'un premier hydrofluorocarbure et dépôt du polymère obtenu sur au moins une surface de l'ensemble électrique,
(ii) polymérisation plasma d'un composé de formule (I) et dépôt du polymère obtenu sur le polymère formé au cours de l'étape (i), et
(iii) polymérisation plasma d'un deuxième hydrofluorocarbure et dépôt du polymère obtenu sur le polymère formé au cours de l'étape (ii).

5. Ensemble électrique selon l'une quelconque des revendications précédentes, le ou les composés de formule (I) étant du 1,4-diméthylbenzène, 1,3-diméthylbenzène, 1,2-diméthylbenzène, toluène, 4-méthylstyrène, 3-méthylstyrène, 2-méthylstyrène, 1,4-divinylbenzène, 1,3-divinylbenzène ou 1,2-divinylbenzène.

6. Ensemble électrique selon l'une quelconque des revendications précédentes, le ou les hydrofluorocarbures étant CF₄, C₂F₄, C₂F₆, C₃F₆, C₃F₈ ou C₄F₈.

7. Ensemble électrique selon l'une quelconque des revendications précédentes, le ou les composés de formule (I) étant du 1,4-diméthylbenzène et le ou les hydrofluorocarbures étant C₃F₆.

8. Ensemble électrique selon l'une quelconque des revendications précédentes, comprenant un substrat comportant un matériau isolant, une pluralité de pistes conductrices présentes sur au moins une surface du substrat, et au moins un composant électrique connecté à au moins une des pistes conductrices.

9. Ensemble électrique selon la revendication 8, le revêtement conforme protégeant la pluralité de pistes conductrices, l'au moins un composant électrique et la surface du substrat sur laquelle sont situés la pluralité de pistes conductrices et l'au moins un composant électrique.

10. Procédé pour revêtir un ensemble électrique de manière conforme, ledit procédé comprenant les étapes suivantes :
(a) polymérisation plasma d'un composé de formule (I) tel que défini dans la revendication 1 et dépôt du polymère obtenu sur au moins une surface de l'ensemble électrique, et
(b) polymérisation plasma d'un hydrofluorocarbure et dépôt du polymère obtenu sur le polymère formé au cours de l'étape (a).

11. Procédé pour revêtir un ensemble électrique de manière conforme, ledit procédé comprenant les étapes suivantes :
(i) polymérisation plasma d'un hydrofluorocarbure et dépôt du polymère obtenu sur au moins une surface de l'ensemble électrique, et
(ii) polymérisation plasma d'un composé de formule (I) tel que défini dans la revendication 1 et dépôt du polymère obtenu sur le polymère formé au cours de l'étape (i).

12. Procédé selon la revendication 10, ledit procédé comprenant les étapes suivantes :
(a) polymérisation plasma d'un premier composé de formule (I) et dépôt du polymère obtenu sur au moins une surface de l'ensemble électrique,
(b) polymérisation plasma d'un premier hydrofluorocarbure et dépôt du polymère obtenu sur le polymère formé au cours de l'étape (a),
(c) polymérisation plasma d'un deuxième composé de formule (I) et dépôt du polymère obtenu sur le polymère formé au cours de l'étape (b), et
(d) polymérisation plasma d'un deuxième hydrofluorocarbure et dépôt du polymère obtenu sur le polymère formé au cours de l'étape (c).

13. Procédé selon la revendication 11, ledit procédé comprenant les étapes suivantes :
(i) polymérisation plasma d'un premier hydrofluorocarbure et dépôt du polymère obtenu sur au moins une surface de l'ensemble électrique,
(ii) polymérisation plasma d'un composé de formule (I) et dépôt du polymère obtenu sur le polymère formé au cours de l'étape (i), et
(iii) polymérisation plasma d'un deuxième hydrofluorocarbure et dépôt du polymère obtenu sur le polymère formé au cours de l'étape (ii).

14. Procédé selon l'une quelconque des revendications 10 à 13, l'ensemble électrique comprenant un substrat comportant un matériau isolant, une pluralité de pistes conductrices présentes sur au moins une surface du substrat, et au moins un composant électrique connecté à au moins une piste conductrice.

15. Procédé selon la revendication 14, comprenant les étapes de polymérisation plasma d'un composé de formule (I) et de dépôt du polymère obtenu sur la pluralité de pistes conductrices, sur l'au moins un composant électrique et sur la surface du substrat sur laquelle sont situés la pluralité de pistes conductrices et l'au moins un composant électrique.
